# DEMANDE DE BREVET EUROPEEN

(11) **EP 4 203 074 A1**
(43) Date de publication de la demande: **28.06.2023**
(21) Numéro de dépôt: 22215319.9
(22) Date de dépôt: 21.12.2022
(51) Int. Cl.: H01L 31/0216, H01L 31/048

(54) **MODULE PHOTOVOLTAÏQUE DOTÉ D'UNE COUCHE BARRIÈRE À LA PERMÉATION D H2O GAZEUX**

(30) Priorité: 21.12.2021 FR 2114093
(71) Demandeur: Commissariat à l'Energie Atomique et aux Energies Alternatives, 75015 Paris (FR)
(72) Inventeur: BRIZE, Virginie, 38054 Grenoble cedex 09 (FR); CROS, Stéphane, 38054 Grenoble cedex 09 (FR)
(74) Mandataire: Germain Maureau

(57) **Abrégé**

Module photovoltaïque (100) comprenant :
- plusieurs cellules photovoltaïques (1a,1b) disposées côte à côte, et reliées électriquement entre elles,
- un ensemble encapsulant (2), configuré pour encapsuler les cellules photovoltaïques (1a,1b), et
- une couche barrière (3) disposée à une interface entre l'ensemble encapsulant (2) et au moins une cellule photovoltaïque (1a,1b), la couche barrière (3) étant configurée pour recouvrir au moins en partie l'au moins une cellule photovoltaïque (1a,1b), et pour présenter un taux de transmission d'Oz gazeux plus faible que celui de l'ensemble encapsulant (2), et un taux de transmission de vapeur d'eau inférieur ou égal à 10⁻²g/m²/jour mesuré à 38°C sous un taux d'humidité de 85 %, de sorte à former une barrière à la transmission de la vapeur d'eau et d'Oz gazeux.

## Description

La présente invention se rapporte au domaine des modules photovoltaïques. L'invention concerne en particulier une architecture spécifique d'un module photovoltaïque comprenant une couche barrière à la perméation gazeuse et notamment d'H₂O gazeux. Selon un deuxième aspect, l'invention se rapporte au procédé de fabrication dudit module photovoltaïque.

Les cellules solaires de nouvelles générations comprenant un matériau semi-conducteur de pérovskite permettent d'obtenir des dispositifs de haut rendement de conversion. Les panneaux photovoltaïques fabriqués à partir de cellules à couche mince à base de pérovskite seule, peuvent être fabriqués à basse température sur un substrat rigide, tel que du verre, ou sur un substrat souple, tel que du PET par exemple. Ceci permet d'envisager des applications à la fois sur support rigide ou sur support flexible. Il est également possible de réaliser des cellules tandem comportant deux types de sous cellules, l'une en pérovskite, l'autre en silicium ou en alliage de CIGS (acronyme pour un alliage composé de Cuivre, Indium, gallium, et de Sélénium) par exemple.

Beaucoup d'efforts aujourd'hui visent à améliorer les rendements et augmenter la durée de vie des modules photovoltaïques sans perdre en efficacité. Les modules sont en effets soumis à des conditions drastiques de température et d'humidité, ils doivent supporter les gaz atmosphériques, tel que l'eau, l'oxygène, et des molécules gazeuses provenant de la décomposition de matériaux constitutifs du panneau photovoltaïque lui-même. Il est notamment connu que l'encapsulant EVA (Ethylene-Vinyl Acetate) destiné à encapsuler et protéger les cellules, se décompose en acide acétique au cours du temps, sous l'effet d'important cyclages thermiques. Or cet acide gazeux est corrosif pour les constituants des cellules.

Cette problématique de stabilité dans le temps est encore accentuée avec l'usage de matériaux sensibles aux mécanismes de dégradation liés à la présence d'eau et d'oxygène ou autre molécule oxydante, tel qu'un semi-conducteur pérovskite ou organique... qui présentent une sensibilité accrue aux gaz de l'atmosphère. Cette contrainte implique de définir des procédés d'encapsulation plus rigoureux que ceux employés aujourd'hui, c'est-à-dire des procédés qui limitent considérablement les quantités de gaz/molécules oxydantes atteignant le dispositif solaire. Ces procédés seront également bénéfiques aux technologies plus traditionnelles à base de silicium par exemple en permettant d'allonger encore la durée de vie des panneaux solaires.

Un des buts de la présente l'invention vise à pallier au moins l'un des inconvénients précités. A cet effet, l'invention propose un module photovoltaïque comprenant :
- plusieurs cellules photovoltaïques disposées côte à côte, et reliées électriquement entre elles,
- un ensemble encapsulant configuré pour encapsuler les cellules photovoltaïques, et
- une couche barrière disposée à une interface entre l'ensemble encapsulant et au moins une cellule photovoltaïque, la couche barrière étant configurée pour recouvrir au moins en partie l'au moins une cellule photovoltaïque, et pour présenter un taux de transmission d'Oz gazeux plus faible que celui de l'ensemble encapsulant, et un taux de transmission de vapeur d'eau inférieur ou égal à 10⁻²g/m²/jour mesuré à 38°C sous un taux d'humidité de 85 %, de sorte à former une barrière à la transmission de la vapeur d'eau et d'O₂ gazeux.

Le module de l'invention ainsi configuré comprend une couche barrière disposée entre l'ensemble encapsulant et la cellule photovoltaïque de sorte à bloquer les possibilités d'entrée de gaz de l'atmosphère au travers de l'ensemble encapsulant. Ceci offre une garantie supplémentaire pour la durabilité du module photovoltaïque, qui est d'autant plus intéressante que les cellules concernées comprennent un matériau semi-conducteur ou toute autre couche constituante de la cellule sensible aux gaz, tel que H₂O et Oz gazeux, ou à un gaz provenant de la dégradation de l'encapsulant EVA ou autre matériau constitutif du module.

Par les termes 'une barrière à la transmission', il est entendu dans le présent document une barrière qui permet de réduire significativement la perméation desdits gaz dans la cellule. Lesdits gaz diffusent notamment au travers de l'ensemble encapsulant et sont majoritairement arrêtés pas la couche barrière.

Ce taux de transmission de vapeur d'eau de la couche barrière permet de limiter la perméation de H₂O gazeux. Ce taux est également bien connu de l'homme de l'art sous l'acronyme anglo-saxon WVTR (pour Water Vaport Transmission Rate). Ce taux est par exemple mesuré selon l'une des normes suivantes: - ASTM E96, DIN 53122 ou ISO 2528. Il est par ailleurs bien connu que même si ce taux traduit avant tout une propriété barrière à la vapeur d'eau, une telle valeur peut constituer également une garantie contre la perméation aux gaz d'Oz, à l'acide acétique et l'amoniaque.

Selon une possibilité, le module photovoltaïque comprend une pluralité de couches barrières, chacune étant disposée entre l'ensemble encapsulant et une cellule photovoltaïque respective. Cette disposition est notamment rencontrée lorsque le module photovoltaïque comprend des cellules photovoltaïques ayant chacune un substrat distinct.

Selon un mode concret de réalisation, la couche barrière comprend un matériau choisi parmi les oxydes de silicium, les oxydes de titane, l'alumine, ou un empilement multicouche de plusieurs de ces matériaux.

Selon une possibilité, la couche barrière est uniquement constituée d'un matériau choisi parmi les oxydes de silicium, les oxydes de titane, l'alumine, ou un empilement multicouche de plusieurs de ces matériaux.

Selon une disposition, la couche barrière comprend un empilement multicouche d'alumine, et d'oxyde de silicium.

Selon une autre disposition, la couche barrière comprend un empilement multicouche d'alumine, et d'oxyde de titane.

Selon une variante, la couche barrière comprend un empilement multicouche d'alumine, d'oxyde de titane et d'oxyde de silicium.

Selon une autre variante, la couche barrière est uniquement constituée d'alumine.

En particulier, la couche barrière présente une épaisseur comprise entre 15 et 50 nm, notamment une épaisseur comprise entre 20 et 40 nm et en particulier une épaisseur d'environ 30 nm. La valeur du taux WVTR diminue c'est-à-dire la protection procurée est maximale pour un optimum en épaisseur qui dépendra des détails de procédé ou de faible variation de la composition chimique (taux d'hydroxyde dans la couche par exemple). Plus la couche est barrière à l'eau, plus elle limite les risques de perméation pour d'autres gaz également. Par ailleurs, il est également nécessaire de trouver un bon compromis entre l'épaisseur de la couche barrière et ses propriétés optiques, électriques, les coûts de fabrication, la durée de son dépôt..., pour un usage optimal dans une cellule. Par exemple, plus la couche d'alumine est épaisse plus sa transmission de la lumière est réduite.

Selon une disposition, l'au moins une cellule photovoltaïque comprend au moins une couche sensible, qui est susceptible de se dégrader en présence d'humidité et/ou d'Oz gazeux, et la couche barrière recouvre au moins en partie ladite au moins une couche sensible.

Dans une variante de réalisation, la couche sensible est disposée au sein de la cellule photovoltaïque. C'est par exemple le cas lorsque la couche sensible est une couche active. Dans cette situation, la couche barrière recouvre l'au moins une couche sensible sans être à son contact.

Sans contradiction avec le fait que la couche barrière recouvre au moins en partie ladite au moins une couche sensible, la présente invention prévoit le fait que la couche barrière recouvre au moins en partie des bords latéraux de l'au moins une cellule photovoltaïque et au moins une face parmi une face avant et une face arrière de l'au moins une cellule photovoltaïque. Dans ce cas, la couche barrière est alors avantageusement disposée sur la face de la cellule qui est la plus susceptible d'être traversée par H₂O gazeux. Il peut s'agir d'une face dénuée d'élément barrière, c'est-à-dire dénué d'une couche ou un substrat présentant par exemple un taux WVTR au moins inférieur à 10⁻²g/m²/jour, tel qu'un substrat de silicium ou une plaque de verre comme on le verra plus en détail par la suite.

Par convention, il est entendu dans le présent document que la 'face avant' d'une cellule photovoltaïque ou d'un module photovoltaïque est la face destinée à recevoir un flux lumineux. Réciproquement, la face arrière est une face située du coté opposé à la face avant.

Selon une possibilité, les cellules photovoltaïques sont des cellules tandem ayant chacune un substrat distinct. Chaque cellule tandem comporte une sous-cellule supérieure comprenant au moins une couche sensible, et la couche barrière recouvre au moins en partie des bords latéraux et au moins une face avant d'au moins l'une des cellules photovoltaïques. Il est entendu dans le présent document que la 'sous-cellule supérieure' est celle qui est destinée à recevoir un flux lumineux en premier, par comparaison avec une sous-cellule inférieure. Dans cette configuration, la sous-cellule inférieure est à base de silicium ou à base d'une couche de CIGS déposée sur substrat métallique, et forme une barrière efficace à la perméation depuis la face inférieure. La sous-cellule supérieure comprenant la couche sensible est sous-jacente à la face avant de la cellule photovoltaïque de sorte que la couche barrière est avantageusement déposé sur la face avant.

Dans un cas particulier, la couche barrière recouvre au moins en partie les bords latéraux et au moins une face avant de chacune des cellules photovoltaïques.

Selon une autre disposition, les cellules photovoltaïques ont chacune un substrat distinct, et sont reliées électriquement entre elles par des contacts électriques comprenant au moins un ruban de connexion électrique déposé sur la couche barrière de chacune des cellules photovoltaïques de sorte à former un réseau d'interconnexion électrique, le réseau d'interconnexion électrique étant relié respectivement à la cathode et à l'anode du module photovoltaïque par une première connexion électrique de sortie et une deuxième connexion électrique de sortie déposées sur la couche barrière.

La connexion du réseau d'interconnexion électrique à la catthode et à l'anode est également connue par l'homme du métier sous l'expression 'reprise de contact'.

Selon une possibilité, chacun des contacts électriques est un ruban de connexion électrique déposé sur la couche barrière de chaque cellule photovoltaïque.

De manière concrète, le ruban de connexion électrique est un adhésif conducteur électrique sensible à la pression, tel que le ruban collecteur de charge 3007 fourni par la société 3M^{®} (également connue sous la dénomination 3M^{™} Charge-Collection Solar Tape 3700).

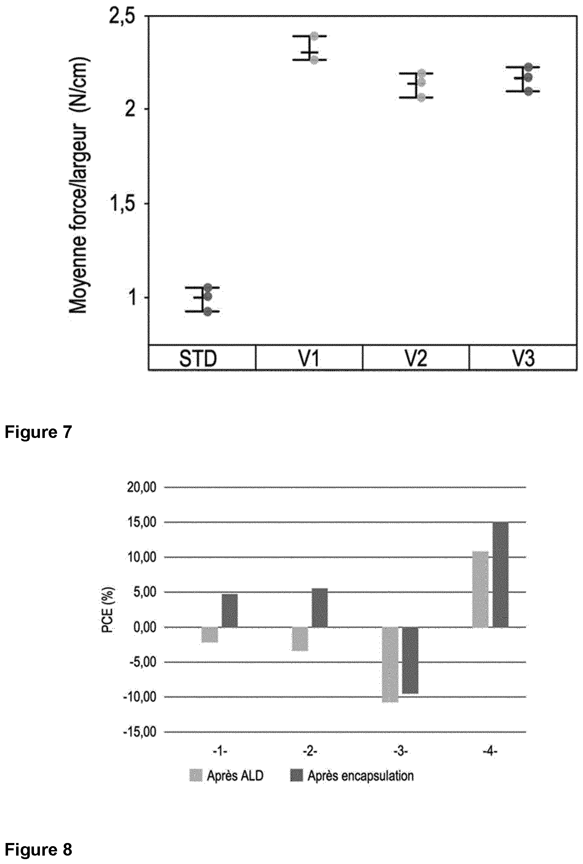

Comme on le verra en détail dans la partie descriptive du présent document, cette disposition des contacts électriques sur la couche barrière permet étonnement une bonne prise de contact électrique et conduit à une cellule qui donne les performances les plus élevées par comparaison avec d'autres cellules testées et dans lesquelles les contacts sont réalisés préalablement à la couche barrière (se reporter à la figure 7). Cette configuration est d'autant plus avantageuse qu'elle facilite la prise des contacts électriques. Les étapes de masquage de zones de contact sur chacune des cellules préalablement à la formation de la couche barrière n'ont pas lieu d'être. Ceci évite également la génération de courant de fuite.

Selon une variante de réalisation, les cellules photovoltaïques comprennent des cellules à couche mince à base de pérovskite, formées sur un substrat commun (également dénommé `support ' commun par l'homme du métier), et la couche barrière recouvre au moins en partie des bords latéraux et au moins une face arrière de l'au moins une des cellules photovoltaïques. Dans cette configuration, la face arrière reste effet, la plus susceptible d'être perméable à H₂O gazeux. Lorsque la couche active de cellules à couche mince est en pérovskite, celles-ci sont formées par dépôt sur un support commun, telle qu'une plaque de verre, hautement barrière à la perméation d'H₂O (WVTR inférieur à 10⁻²g/m²/jour). Puis, en vue de son utilisation de la cellule, la structure sera retournée et le support sera disposé en face avant du module. La couche barrière de l'invention est alors avantageusement disposée en face arrière, dénuée d'élément de protection.

Dans cette disposition dans laquelle les cellules photovoltaïques sont formées sur un substrat commun, les cellules photovoltaïques sont reliées électriquement entre elles par un réseau d'interconnexion interne, la reprise des contacts entre le réseau d'interconnexion interne, la cathode et l'anode du module photovoltaïque sont réalisées respectivement par une première connexion électrique de sortie, et une deuxième connexion électrique de sortie déposées sur la couche barrière.

Cette configuration est également avantageuse en ce que la prise de contact électrique est obtenue à travers la couche barrière.

Selon une disposition, le module photovoltaïque comprend en outre une première couche de protection et une deuxième couche de protection opposée, la première couche de protection et la deuxième couche de protection étant laminées de part et d'autre de l'ensemble encapsulant, dans lequel sont encapsulées les cellules photovoltaïques, les contacts électriques et la couche barrière.

Dans le présent document, l'expression 'couche de protection' signifie également 'capot de protection' selon une terminologie bien connue de l'homme de l'art.

Selon une possibilité, la première couche de protection et la deuxième couche de protection sont respectivement disposées sur la face avant et la face arrière d'au moins une cellule de la pluralité de cellules photovoltaïques.

Selon une possibilité, l'ensemble encapsulant est réalisé à partir d'au moins un matériau polymère choisi parmi l'éthylène-acétate de vinyle (ou EVA acronyme anglosaxon pour Ethylene-Vinyl Acetate), des ionomères, notamment les Surlyn^{®}, le PV5400 et le PV8600 disponible chez Dupont^{™} et des combinaisons de ces composés.

Selon un possibilité, l'ensemble encapsulant est formé d'au moins une couche d'encapsulation en ledit au moins un matériau polymère, configurée pour encapsuler les cellules photovoltaïques.

Selon une autre disposition, l'ensemble encapsulant est formé par un moins un premier film d'encapsulation disposé sur au moins l'une parmi la face avant et la face arrière des cellules photovoltaïques et au moins un second film d'encapsulation disposé sur une face opposée des cellules photovoltaïques, les au moins premier et second films d'encapsulation étant en au moins un matériau polymère, destiné(s) à fondre dans une étape ultérieure de lamination, permettant l'encapsulation des cellules photovoltaïques et également de faire adhérer la première couche de protection et la deuxième couche de protection et conduire à une structure multicouche formant le module photovoltaïque.

Par l'expression 'sur' on entend dans le présent document 'au contact direct' ou 'au contact indirect'.

Le premier film d'encapsulation et le second film d'encapsulation sont soit réalisés avec le même matériau polymère, soit avec des matériaux polymères différents.

Selon une possibilité, le premier film d'encapsulation et/ou le second film d'encapsulation comprennent chacun une composition multicouche.

Lorsque l'ensemble encapsulant est constitué d'EVA, celui-ci se dégrade en acide acétique au cours du temps et la couche barrière forme avantageusement une barrière au passage de l'acide acétique vers l'au moins une cellule photovoltaïque.

Selon une possibilité, le module photovoltaïque comprend au moins un joint d'étanchéité disposé contre un bord latéral périphérique de l'ensemble encapsulant. Ce joint d'étanchéité limite l'éventuelle perméation latérale dans le module photovoltaïque, pour des gaz que l'ensemble encapsulant et la couche barrière ne stopperait pas totalement, notamment lorsque l'ensemble encapsulant est en EVA. Le joint d'étanchéité est bien entendu disposé entre la première couche de protection et la deuxième couche de protection.

De manière concrète, le joint d'étanchéité est un PolylsoButylène, également connu sous l'acronyme anglo-saxon PIB, tel que le produit B-dry disponible auprès de la société SAES Getters Group.

Selon un deuxième aspect, l'invention propose un procédé de fabrication d'un module photovoltaïque tel que précédemment décrit, dans lequel la couche barrière est réalisée par un procédé de dépôt de couche atomique. Ce procédé de dépôt de couche atomique est bien connu de l'homme de l'art sous l'expression ALD (acronyme anglo-saxon de Atomic Layer Déposition). Ce procédé permet de déposer des couches à l'échelle atomique ce qui garantit une grande précision de dépôt. Une recette de dépôt standard d'alumine par exemple comprend une répétition de plusieurs centaines de cycles comportant un pulse d'H₂O, une purge d'H₂O avec N₂, un pulse de TMA (acronyme de TriMéthylAluminium) et une purge de TMA avec N₂.

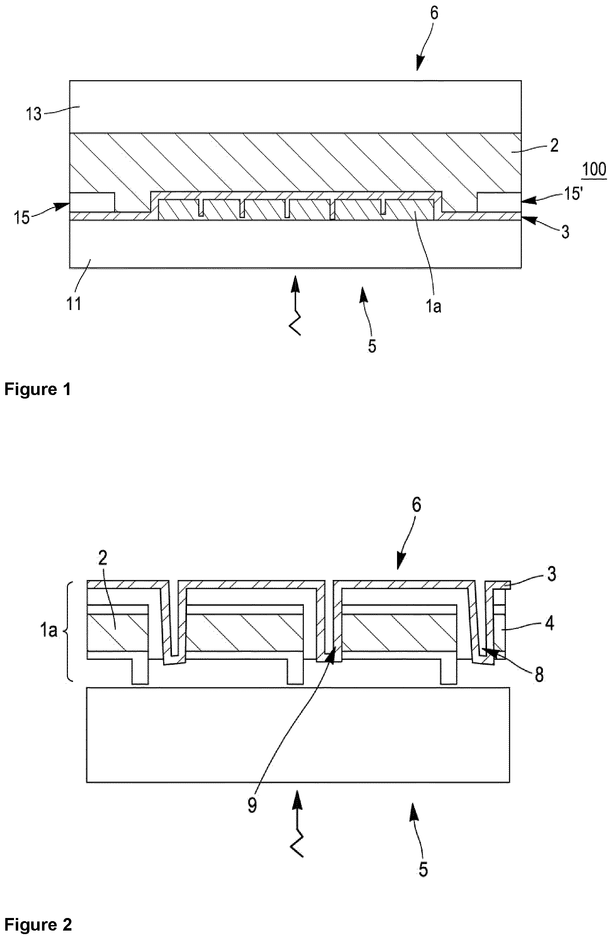

De manière concrète, le procédé de dépôt de couche atomique par ALD selon l'invention se termine par un cycle constitué par un pulse oxydant d'H₂O de sorte à obtenir des liaisons hydroxyles en surface de la couche barrière, suivi d'une purge avec un gaz neutre, tel que N₂ ou Ar, de sorte à retirer les sous-produits de réaction, notamment lorsque la couche barrière est en alumine ou qu'elle présente une face exposée au dépôt de l'encapsulant en alumine. Ce dernier cycle d'ALD facilite l'adhésion ultérieure avec l'au moins une couche d'encapsulation, formée par exemple en ionomère ou en EVA lors de la réalisation de l'ensemble encapsulant (se reporter à la figure 2).

Selon une possibilité, le dépôt de couche atomique est réalisé à une température inférieure à 130°C, et de préférence à une température d'environ 100°C. Ces températures se trouvent dans une moyenne basse comparée aux températures standard. Elles limitent les risques de dégradation des couches des cellules photovoltaïques.

De manière concrète, le procédé comprend une étape i) de liaison électrique des cellules photovoltaïques entre elles par dépôt d'un ruban de connexion électrique sur la couche barrière de chacune des cellules photovoltaïques, notamment lorsque les cellules photovoltaïques ont chacune un substrat distinct, et/ou une étape ii) de reprise des contacts réalisée par formation d'une première connexion électrique de sortie et d'une deuxième connexion électrique de sortie sur la couche barrière.

Cette disposition permet des contacts au travers de la couche barrière et d'obtenir des performances améliorées par comparaison au procédé dans lequel la disposition des rubans de contacts et/ou les connexions électriques sont déposés avant l'étape de dépôt de la couche barrière.

Il est à noter que les connexions électriques de sortie sont nécessaires pour les modules photovoltaïques de cellules ayant chacune un substrat distinct comme pour les modules photovoltaïques de cellules formées sur un substrat commun, pour une reprise de contact entre le réseau reliant les cellules à la cathode et à l'anode du module photovoltaïque.

Selon une disposition, le procédé comprend en outre :
- une étape j) de formation d'une structure multicouche formée successivement par :
   - la première couche de protection,
   - au moins un premier film d'encapsulation,
   - les cellules photovoltaïques reliées électriquement entre elles,
   - au moins un second film d'encapsulation, et
   - une deuxième couche de protection, et
- une étape k) de lamination de la structure multicouche obtenue à l'étape j) de manière à former l'ensemble encapsulant à partir du premier film d'encapsulation et du second film d'encapsulation, l'ensemble encapsulant, configuré pour encapsuler les cellules photovoltaïques, étant disposé entre les première et deuxième couches de protection.

L'étape k) de lamination du module photovoltaïque comprend l'application d'une température inférieure ou égale à 130 degrés Celsius.

De manière concrète, l'étape k) de lamination est réalisée avec une pression d'environ 100 kPa (1000 mbar).

Selon d'autres caractéristiques, le module photovoltaïque selon l'invention comporte une ou plusieurs des caractéristiques optionnelles suivantes considérées seules ou en combinaison :
- la couche barrière comprend des liaisons hydroxyles à sa surface. Ceci facilite l'adhésion avec l'au moins une couche d'encapsulation.
- la première couche de protection disposée sur la face avant est constituée par un substrat transparent, tel qu'une plaque de verre transparent, un empilement transparent de polymères, comprenant par exemple un polymère de la famille des acrylates, tel que le polyméthacrylate de méthyle (PMMA) ou une composition 510-F disponible auprès de la société 3M^{®} comprenant un film de fluoropolymère transparent et un film de PET assemblée par une couche adhésive sensible à la pression.
- la deuxième couche de protection disposée sur la face arrière est constituée par un substrat transparent, tel qu'une plaque de verre transparent, ou une multicouche contenant du PET entre deux couches de polymères fluorés tel que le PVF ou le PVDF.
- la première couche de protection ou la deuxième couche de protection comprend le substrat commun sur lequel sont formées aux cellules photovoltaïques.

D'autres aspects, buts et avantages de la présente invention apparaîtront mieux à la lecture de la description suivante de deux modes de réalisation de celle-ci, donnée à titre d'exemple non limitatif et faite en référence aux dessins annexés. Dans la suite de la description, par souci de simplification, des éléments identiques, similaires ou équivalents des différentes formes de réalisation portent les mêmes références numériques. Les figures ne respectent pas nécessairement l'échelle de tous les éléments représentés de sorte à améliorer leur lisibilité et dans lesquelles :
Figure 1 représente une vue schématique en coupe d'une partie d'un module photovoltaïque de cellules à couche mince selon un premier mode de réalisation de l'invention.
Figure 2 représente une vue schématique agrandie d'une cellule à couche mince selon le mode de réalisation de la figure 1.
Figure 3 représente une vue schématique du dessus d'une partie d'un module photovoltaïque de cellules à couche mince selon le mode de réalisation de la figure 1.
Figure 4 représente une vue schématique en coupe d'une partie d'un module photovoltaïque de cellules tandem selon un deuxième mode de réalisation de la présente invention.
Figure 5 représente une vue schématique agrandie d'une cellule tandem selon le mode de réalisation de la figure 4.
Figure 6 représente une vue schématique du dessus d'une partie d'un module photovoltaïque de cellules tandem selon le mode de réalisation de la figure 4.
Figure 7 représente des résultats de mesures expérimentales de la force d'adhésion d'un ensemble encapsulant sur une couche barrière en alumine selon différentes recettes de dépôt de la couche barrière.
Figure 8 représente des résultats de mesures expérimentales de rendement de différentes cellules comprenant des contacts électriques déposés avant ou après le dépôt de la couche barrière d'alumine.

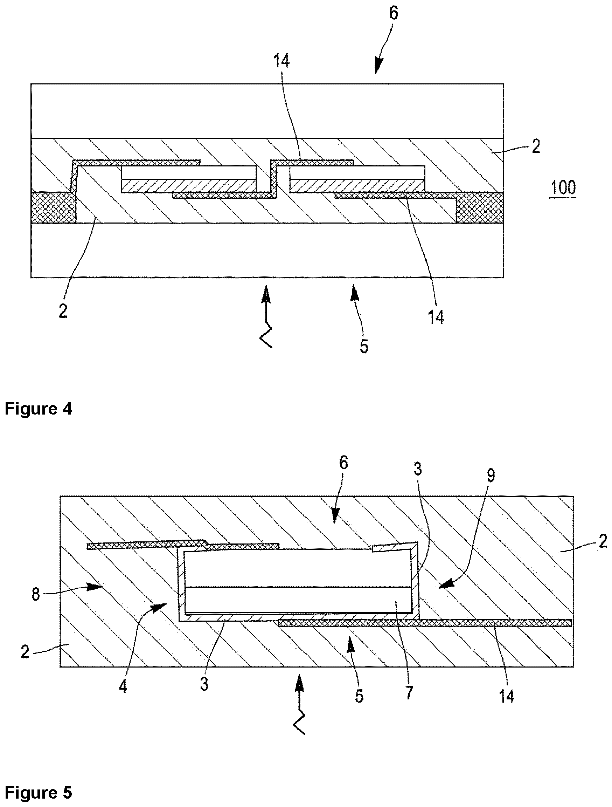

Comme illustré sur les figures, l'invention se rapporte à un module photovoltaïque 100 comprenant des cellules photovoltaïques 1a, formées et sur un sustrat commun 11 (figures 1 à 3) ou des cellules photovoltaïques 1b ayant chacune un substrat distinct et disposées côte à côte (figures 4 à 6), le module 100 comprenant une couche barrière 3 recouvrant au moins en partie des bords latéraux et une face des cellules photovoltaïques 1a,b, lui même étant encapulsé par un ensemble encaspulant 2.

Dans un premier mode de réalisation illustré aux figures 1 à 3, le module photovoltaïque 100 est formé de plusieurs cellules photovoltaïques à couche mince 1a, formées sur un substrat commun, un ensemble encapsulant 2, et une couche barrière 3 en alumine disposée à l'interface entre l'ensemble encapsulant 2 et les cellules photovoltaïques 1a. Plus précisément, la couche barrière 3 recouvre les cellules photovoltaïques 1a de sorte à former une barrière à la transmission de la vapeur d'eau, de Oz gazeux, voire d'amoniaque ou d'acide acétique (figure 2). La couche barrière 3 est en alumine et présente en effet des taux de transmission à la vapeur d'eau et d'Oz gazeux inférieurs à ceux de l'ensemble encapsulant 2. La couche barrière 3 est déposée par ALD sur une épaisseur d'environ 30 nm de sorte à présenter un taux WVTR inférieur à ou égal à 10⁻²g/m²/jour mesuré à 38°C sous un taux d'humidité de 85 %. Selon des besoins d'efficacité différents de la couche barrièrre, l'épaisseur de la couche varie entre 15 et 50 nm.

Cette couche barrière 3 déposée par ALD est dense, elle présente peu de défaut de sorte qu'une fine épaisseur suffit pour forme une barrière à la transmission de la majorité des gaz. La réalisation de contacts électriques reste possible au travers cette fine épaisseur, comme développé ci-dessous.

Selon des possibilités de réalisation, la couche barrière 3 est en alumine, oxyde de silicium, un oxyde de titane, ou formé d'un empilement multicouche de plusieurs de ces matériaux.

Dans ce premier mode de réalisation, les cellules 1a comprennent une couche sensible 4, c'est-à-dire une couche 4 qui est susceptible de se dégrader plus ou moins rapidement en présence de vapeur d'eau et/ou d'Oz gazeux, par exemple une couche sensible 4 en péroskite ou en matériau organique. Dans ce cas, la couche barrière 3 recouvre ladite couche sensible 4, sans pour autant être au contact direct de celle-ci. L'agrandissement de la figure 2 illustre dans le détail le recouvrement de la couche sensible 4 lorsqu'elle est une couche active se trouvant au sein d'un empilement de couches formant la cellule photovoltaïque. Il est possible d'observer notamment que la couche barrière 3 recouvre au moins en partie des bords latéraux 8,9 de chacune des cellules et au moins la face arrière 6 de la cellule 1a. En effet, la protection de la face avant 5 de la cellule est déjà assurée au moment de sa formation : la cellule à couche mince 1a comprenant la couche de pérovskite est formée à partir d'un support 11 destiné à former la face avant 5 de la cellule (figure 2). Ce support 11 répond à des critères de transparence et il est également choisi pour assurer la fonction de la première couche de protection 11, notamment contre la perméation d'H₂O et Oz gazeux. Le support est alors choisi de sorte à présenter un taux WVTR inférieur à 10⁻² g/m²/jour. Il peut être constitué par une plaque de verre, ou par un film flexible hautement barrière au gaz tel que le film 510-F de la société 3M^{®}.

Dans la mesure où la face arrière 6 de la cellule 1a est protégée par la couche barrière 3 en alumine, la deuxième couche de protection 13 disposée en face arrière 6 du module peut être choisi pour présenter un taux WVTR plus élevé, par exemple inférieur ou égale à 1g/m²/jour (figure 1).

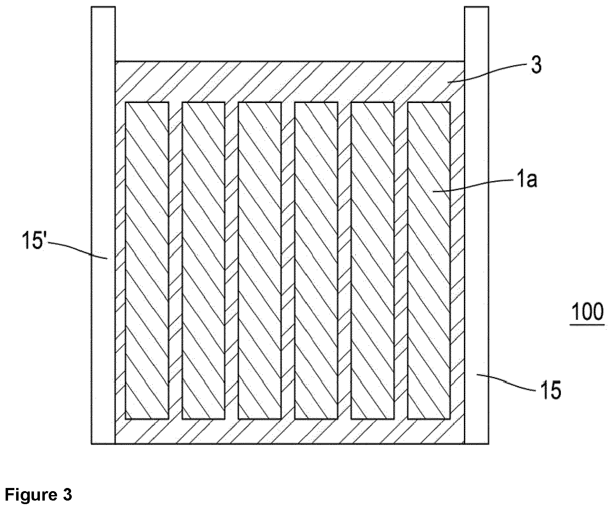

Selon une particularité de ce mode de réalisation, les cellules 1a sont reliées électriquement entre elles par un réseau d'interconnexion interne, la reprise des contacts entre le réseau d'interconnexion interne et la cathode, et réciproquement entre le réseau d'interconnexion interne et l'anode du module photovoltaïque 100 est réalisée respectivement par une première connexion électrique de sortie 15 et une deuxième connexion électrique de sortie 15' déposées sur la couche barrière 3 (étape ii). La figure 3 illustre notamment les connexions électroniques de sortie 15 déposées sur la couche barrière 3. Il s'agit de rubans adhésifs électriquement conducteurs, sensibles à la pression et configurés pour relier le réseau d'interconnexion interne entre les cellules 1a à la cathode et à l'anode.

Un premier film d'encapsulation et un second film d'encapsulation en ionomère ou une combinaison de EVA et de ionomère sont chacun déposés sur une face des cellules photovoltaïques de sorte à former l'ensemble encapsulant 2 lors d'une étape k) de lamination ultérieure.

La première couche de protection 11 et la deuxième couche de protection 13 sont ensuite disposées de part et d'autre des cellules photovoltaïques 1a et leurs contacts électriques 15, 15' et l'étape de lamination est effectuée à une température inférieure ou égale à 130°C et une pression d'environ 100 kPa (1000 mbar étape k), sans affecter le rendement des cellules comme on pourra le voir par la suite sur la figure 8.

Les figures 4 à 6 illustrent un deuxième mode de réalisation de l'invention qui diffère du premier mode et en ce que les cellules sont, en particulier, des cellules tandem 1b ayant chacune un substrat distinct. Ces cellules 1b comprennent une couche active et sensible 4 en pérovskite disposée au sein d'une sous-cellule supérieure 7. La couche barrière 3 est disposée de sorte à recouvrir au moins une face avant 5 et des bords latéraux 8,9 de la cellule 1b (figure 5). La sous-cellule inférieure comprenant un substrat de silicium, ou une couche de CGIS sur un support, forme une barrière efficace à la perméation d'H₂O et Oz gazeux en face arrière 6 (figure 4).

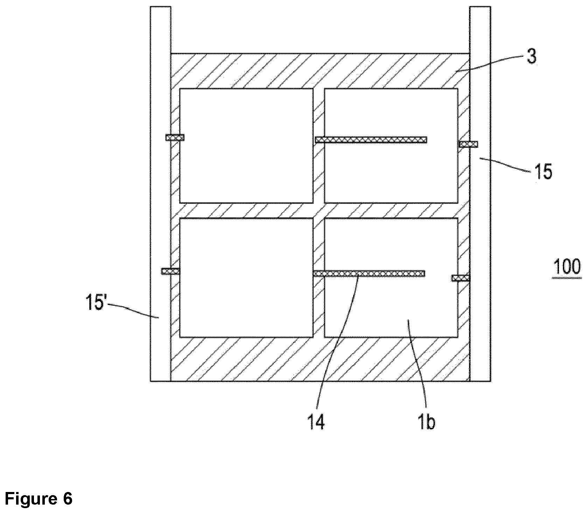

Egalement visible sur la figure 6, les cellules 1b sont reliées électriquement entre elles par des contacts électriques comprenant au moins un ruban de connexion électrique 14 (rubans adhésifs électriquement conducteurs) déposé sur la couche barrière 3 de chacune des cellules 1b, de sorte à former un réseau d'interconnexion électrique (étape i). Le réseau d'interconnexion électrique est ensuite relié respectivement à la cathode et à l'anode du module photovoltaïque 100 par une première connexion électrique de sortie 15 et une deuxième connexion électrique de sortie 15' déposées sur la couche barrière 3 en alumine (étape ii ou 'reprise des contacts') avant la formation de l'ensemble encapsulant 2.

La suite du procédé se déroule selon le même concept que celui des cellules 1a, un ensemble encapsulant 2 est déposé sous forme d'un premier film d'encapsulation et d'un second film d'encapsulation de part et d'autre des cellules 1b, deux couches de protection 11, 13 sont disposées de part et d'autre de la structure 100 (structure multicouche formée à l'étape j) et une étape de lamination est effectuée (étape k).

Selon une disposition non illustrée, un joint d'étanchéité de PIB est disposé contre un bord latéral périphérique de l'ensemble encapsulant 2 avant la disposition des premières et deuxième couche de protection 11,13 de sorte à renforcer la protection des cellules 1a et 1b.

Dans les deux modes de réalisation illustrés sur les figures 1 à 6 se pose la problématique de l'adhésion de l'encapsulant, par exemple en EVA ou en un ionomère, avec la couche barrière 3 en alumine. La figure 7 illustre les effets de différentes recettes de dépôt par ALD de la couche barrière 3 sur l'adhésion avec un ensemble encapsulant 2 à base de ionomère. L'axe des ordonnées illustre la moyenne de la force sur la largeur en N/cm et l'axe des abscisses référence quatre recettes différentes. Avec la recette standard STD comprenant la répétition de cycles comportant : un pulse d'H₂O, une purge d'H₂O avec N₂, un pulse de TMA et une purge de TMA avec N₂, la force d'adhésion est très faible. Avec la recette V1 comprenant les cycles suivants : pulse de TMA et une purge de TMA avec N₂, un pulse d'H₂O, une purge d'H₂O avec N₂, la force d'adhésion est la meilleure. La recette V2 combinant la répétition des cycles de la recette standard et un dernier cycle avec un pulse d'H₂O puis une purge d'H₂O avec N₂ donne également de très bons résultats. La recette V3 reprenant les cycles de la recette standard mais comprenant en fin de chacun des cycles un pulse d'H₂O suivi d'une purge d'H₂O avec N₂ conduit à des résultats similaires. Comme indiqué ci-dessus, l'explication probable à l'augmentation de l'adhésion, malgré une température de dépôt inférieure à 130°C, réside en la formation de liaison hydroxyles en surface de la couche barrière 3 et une purge permettant de retirer les sous-produits de réaction.

La figure 8 illustre des résultats de mesures expérimentales de rendement réalisées après le dépôt de la couche barrière 3 et après la formation de l'ensemble encapsulant 2 à partir de différentes cellules. Les mesures réalisées sur les deux premières cellules montrent des rendements améliorés après formation de l'ensemble encapsulant 2 même si ceux-ci dépassent à peine 5% (l'axe des ordonnées représente le PCE relatif). Les mesures réalisées sur la troisième cellule approchent de 10%. Enfin, les mesures réalisées sur la quatrième cellule dépassent 15% après formation de l'ensemble encapsulant 2. La différence notable entre les deux premières cellules et les deux dernières cellules réside en ce que dans ce dernier cas, les contacts électriques 14, 15, 15' ont été réalisés sur la couche barrière 3 alors que dans les deux premiers cas ils ont été réalisés avant formation de la couche barrière 3.

Ainsi, la présente invention propose un module photovoltaïque 100 comportant une couche barrière 3 à la perméation d'H₂O gazeux qui présente des propriétés barrières à la vapeur d'eau, aux gaz d'Oz, à l'acide acétique et l'amoniaque. La couche barrière 3 aux gaz est en effet une couche inorganique dense (non poreuse, avec une faible densités de défauts) notamment obtenue par une technologie de dépôt ALD. La couche barrière 3 est ainsi peu soumise à des problématiques de solubilité des gaz. Ces dernières peuvent inverser les comportements de transmission selon les gaz (eau et oxygène par exemple) dans le cas des matériaux organiques, tels que les polymères organiques. La couche barrière 3 selon l'invention permet ainsi d'améliorer significativement la durée de vie des cellules d'un module 100, que ces cellules 1 présentent une couche sensible 4 ou non. Cette couche barrière 3 ne gêne pas la prise des contacts électriques 14,15, ce qui facilite le procédé de fabrication et évite les risques de courant de fuite.

## Revendications

1. Module photovoltaïque (100) comprenant :
- plusieurs cellules photovoltaïques (1a,1b) disposées côte à côte, et reliées électriquement entre elles,
- un ensemble encapsulant (2), configuré pour encapsuler les cellules photovoltaïques (1a,1b), et
- une couche barrière (3) disposée à une interface entre l'ensemble encapsulant (2) et au moins une cellule photovoltaïque (1a,1b), la couche barrière (3) étant configurée pour recouvrir au moins en partie l'au moins une cellule photovoltaïque (1a,1b), et pour présenter un taux de transmission d'Oz gazeux plus faible que celui de l'ensemble encapsulant (2), et un taux de transmission de vapeur d'eau inférieur ou égal à 10⁻²g/m²/jour mesuré à 38°C sous un taux d'humidité de 85 %, de sorte à former une barrière à la transmission de la vapeur d'eau et d'Oz gazeux.

2. Module photovoltaïque (100) selon la revendication 1, dans lequel la couche barrière (3) comprend des liaisons hydroxyles à sa surface de sorte à faciliter l'adhésion avec l'ensemble encapsulant (2).

3. Module photovoltaïque (100) selon la revendication 1 ou 2, dans lequel la couche barrière (3) comprend un matériau choisi parmi les oxydes de silicium, les oxydes de titane, l'alumine, ou un empilement multicouche de plusieurs de ces matériaux.

4. Module photovoltaïque (100) selon l'une des revendications 1 à 3, dans lequel la couche barrière (3) présente une épaisseur comprise entre 15 et 50 nm.

5. Module photovoltaïque (100) selon l'une des revendications 1 à 4, dans lequel l'au moins une cellule photovoltaïque (1a,1b) comprend au moins une couche sensible (4) qui est susceptible de se dégrader en présence d'humidité et/ou d'Oz gazeux, et dans lequel la couche barrière (3) recouvre au moins en partie ladite au moins une couche sensible (4).

6. Module photovoltaïque (100) selon l'une des revendications 1 à 5, dans lequel les cellules photovoltaïques (1b) ont chacune un substrat distinct et sont reliées électriquement entre elles par des contacts électriques comprenant au moins un ruban de connexion électrique (14) déposé sur la couche barrière (3) de chacune des cellules photovoltaïques (1b) de sorte à former un réseau d'interconnexion électrique, le réseau d'interconnexion électrique étant relié respectivement à la cathode et à l'anode du module photovoltaïque (100) par une première connexion électrique de sortie (15) et une deuxième connexion électrique de sortie (15') déposées sur la couche barrière (3).

7. Module photovoltaïque (100) selon l'une des revendications 1 à 5, dans lequel les cellules photovoltaïques (1a) sont formées sur un substrat commun et sont reliées électriquement entre elles par un réseau d'interconnexion interne, la reprise des contacts entre le réseau d'interconnexion interne, la cathode et l'anode du module photovoltaïque (100) sont réalisées respectivement par une première connexion électrique de sortie (15) et une deuxième connexion électrique de sortie (15') déposées sur la couche barrière (3).

8. Module photovoltaïque (100) selon l'une des revendications 1 à 7, lequel comprenant en outre une première couche de protection (11) et une deuxième couche de protection (13) opposée, la première couche de protection (11) et la deuxième couche de protection (13) étant laminées de part et d'autre de l'ensemble encapsulant (2), dans lequel sont encapsulées les cellules photovoltaïques (1a,1b), les contacts électriques (14,15) et la couche barrière (3).

9. Module photovoltaïque (100) selon l'une des revendications 1 à 8, lequel comprenant en outre un joint d'étanchéité disposé contre un bord latéral périphérique de l'ensemble encapsulant (2).

10. Procédé de fabrication d'un module photovoltaïque (100) de l'une des revendications précédentes, dans lequel la couche barrière (3) est réalisée par un procédé de dépôt de couche atomique.

11. Procédé de fabrication d'un module photovoltaïque (100) selon la revendication précédente, dans lequel le procédé de dépôt de couche atomique est terminé par un cycle constitué par un pulse oxydant d'H₂O de sorte à obtenir des liaisons hydroxyles en surface de la couche barrière (3), suivi d'une purge avec un gaz neutre.

12. Procédé de fabrication d'un module photovoltaïque (100) selon la revendication 10 ou 11, lequel comprend une étape i) de liaison électrique des cellules photovoltaïques (1b) entre elles par dépôt d'un ruban de connexion électrique (14) sur la couche barrière (3) de chacune des cellules photovoltaïques (1b), notamment lorsque les cellules photovoltaïques (1b) ont chacune un substrat distinct, et/ou une étape ii) de reprise des contacts réalisée par formation d'une première connexion électrique de sortie (15) et d'une deuxième connexion électrique de sortie (15') sur la couche barrière (3).

13. Procédé de fabrication d'un module photovoltaïque (100) selon l'une des revendications 10 à 12, lequel comprend :
- une étape j) de formation d'une structure multicouche formée successivement par :
• la première couche de protection (11),
• au moins un premier film d'encapsulation,
• les cellules photovoltaïques (1a, 1b) reliées électriquement entre elles,
• au moins un second film d'encapsulation, et
• une deuxième couche de protection (13), et
- une étape k) de lamination de la structure multicouche obtenue à l'étape j) de manière à former l'ensemble encapsulant (2) à partir du premier film d'encapsulation et du second film d'encapsulation, l'ensemble encapsulant (2), configuré pour encapsuler les cellules photovoltaïques (1a, 1b), étant disposé entre les première et deuxième couches de protection (11,13).
